Europäisches Patentamt

European Patent Office

Office européen des brevets

(11) Numéro de publication: **0 309 531 B1**

(12) **FASCICULE DE BREVET EUROPEEN**

(45) Date de publication de fascicule du brevet: **16.06.93** (51) Int. Cl.⁵: **G02F  1/09**, H01S 3/00

(21) Numéro de dépôt: **88903272.8**

(22) Date de dépôt: **05.04.88**

(86) Numéro de dépôt internationale :
**PCT/FR88/00166**

(87) Numéro de publication internationale :
**WO 88/08148 (20.10.88 88/23)**

(54) **GUIDE D'ONDE ISOLATEUR MONOMODE INTEGRE ET APPLICATION A UN LASER A SEMICONDUCTEURS.**

(30) Priorité: **07.04.87 FR 8704890**

(43) Date de publication de la demande:
**05.04.89 Bulletin  89/14**

(45) Mention de la délivrance du brevet:
**16.06.93 Bulletin  93/24**

(84) Etats contractants désignés:
**DE GB IT NL**

(56) Documents cités:

**Revue Technique Thomson-CSF, vol. 18, no. 2, June 1986, Gauthier-Villars J.P. Castéra et al.: "Effets magnétooptiques dans les grenants et leur application à la réalisation d'un isolateur et d'un circulateur optiques", pp 255-300**

(73) Titulaire: **THOMSON-CSF**
**51, Esplanade du Général de Gaulle**
**F-92800 Puteaux(FR)**

Titulaire: **ETAT FRANCAIS**
**38, rue du Général-Leclerc**
**F-92131 Issy-les-Moulineaux(FR)**

(72) Inventeur: **CASTERA, Jean-Paul**
**3, résidence "Le Coteau"**
**F-91400 Orsay(FR)**
Inventeur: **MEUNIER, Paul-Louis**
**23, avenue du Docteur-Arnold-Netter**
**F-75102 Paris(FR)**
Inventeur: **CARENCO, Alain**
**68 ter, avenue Foch**
**F-92260 Fontenay-aux-Roses(FR)**
Inventeur: **DUPONT, Jean-Marie**
**12, rue de Valois**
**F-91940 Les Ulis(FR)**

Applied Optics, vol. 25, no. 12, 15 June 1986, S. Matsumoto et al.: "Temperature-stable Faraday rotator material and its use in high-performance optical isolators", pp 1940-1945

Optical and Quantum Electronics, vol. 10, no. 5, September 1978, Chapman and Hall Ltd. (GB), H. Iwamura et al.: "A compact optical isolator using a $Y_3Fe_5O_{12}$ crystal for near infra-red radiation", pp 393-398.

Conférence Européenne sur les Communications Optiques, 21-24 September 1982, (Cannes, FR), R.C. Booth et al.: "Isolateurs magnétooptiques $Yb_3Fe_5O_{12}$ à large bande", pp 238-243.

Journal of Lightwave Technology, vol. LT-2, no. 2, April 1984, IEEE (New York, US), S. Hava et al.: "Monolithically peltiercooled laser diodes", pp 175-180.

Electronic Letters, vol. 20, no. 25/26, 6 December 1984 (Stévenage, Herts, GB), R.C. Booth et al.: "Temperature tuning of $LiNbO_3$ electro-optic waveguide TE/TM mode converters", pp 1045-1047.

Inventeur: **FRIEZ, Pierre**
**10, rue Rubens**
**F-75010 Paris(FR)**

(74) Mandataire: **Grynwald, Albert et al**
**THOMSON-CSF, SCPI, B.P. 329, 50, rue Jean-Pierre Timbaud**
**F-92402 Courbevoie Cédex (FR)**

## Description

L'invention concerne un isolateur monomode intégré et notamment un dispositif de guidage permettant de coupler une diode laser à des circuits optiques, tout en interdisant efficacement le retour d'énergie lumineuse vers la diode laser.

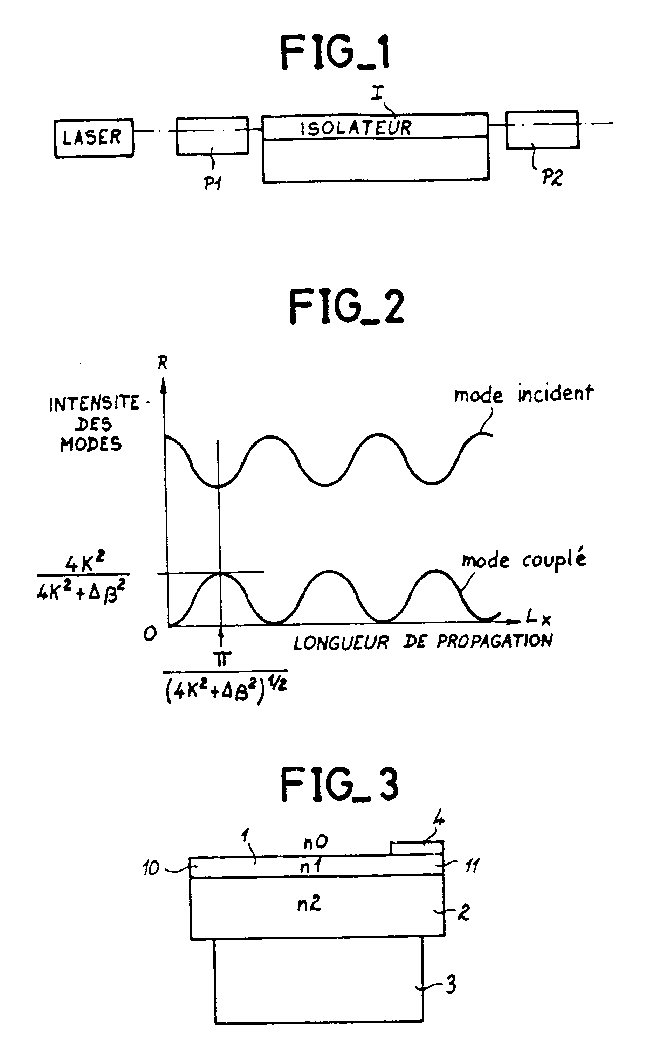

A titre d'exemple, pour illustrer l'état de la technique, la figure 1 représente le schéma d'un isolateur et son fonctionnement. Ce dispositif est composé d'un tronçon non-réciproque I et de deux polariseurs P1, P2 correctement orientés. Dans la section non-réciproque I, constituée d'un tronçon de YIG, le plan de polarisation de la lumière incidente tourne de 45° par effet Faraday. Toute lumière réfléchie aura, après un second passage dans ce tronçon, une polarisation croisée avec le polariseur d'entrée. L'effet d'isolation est alors obtenu.

En optique intégrée, la lumière se propage dans une couche mince de grenat d'yttrium et de fer dopé, par exemple, avec des ions gadolinium et gallium, sous forme de modes propres de type TE et TM (guide plan) ou E et H (guide bidimensionnel). L'effet Faraday couple les modes TE et TM ou E et H. Ainsi pour un guide plan monomode, en supposant que l'onde incidente à l'entrée du guide a une polarisation parallèle au mode $TE_o$, l'intensité R convertie de façon non-réciproque en $TM_o$ en un point situé à une distance Lx de l'entrée du guide aura pour expression :

$$R \; = \; \frac{I_{TM_o}(L)}{I_{TE_o}(o)} \; = \; \frac{4K^2}{4K^2 + \Delta\beta^2} \; \sin^2\left[\frac{1}{2}\sqrt{4K^2 + \Delta\beta^2} \quad L\right] \; (1)$$

où K est la constante Faraday:

$\Delta\beta = \frac{2\pi}{\lambda} \Delta N$ avec $\Delta N = N_{TE_o} - N_{TM_o}$, $N_{TE_o}$ et $N_{TM_o}$ étant respectivement les indices effectifs des modes $TE_o$ et $TM_o$.

La figure 2 représente la variation de R en fonction de L. La relation (1) montre que pour K constant, la conversion n'est complète (R = 1) que si $\Delta\beta = 0$. Dans ce cas, les modes sont dégénérés et on obtient une conversion totale pour une distance de propagation $Z_0$ telle que $Z_0 = \frac{\pi}{2K}$. Pour $\Delta\beta \neq 0$ le taux de conversion maximum $R_M$ donné par (1) satisfait:

$$R_M \; = \; \frac{4K^2}{4K^2 + \Delta\beta^2} \qquad (2)$$

Ainsi, pour une couche de grenat d'yttrium et de fer (YIG) substitué par des ions gadolinium et gallium de 3 μm d'épaisseur dont l'indice de réfraction n ≃ 2,15 et la rotation Faraday K = 206°/cm à λ = 1,15 μm, $\Delta\beta$ = 1633 °/cm, ce qui donne RM ≃ 1,6%.

Par analogie avec l'optique non guidée, un isolateur en optique intégrée utilise un tronçon non-réciproque dont la longueur correspond à une conversion de 50% dans le sens ALLER et 50% dans le sens RETOUR. Cette section est complétée par un polariseur a l'entrée et un polariseur à la sortie. Un seul polariseur peut suffire. C'est le cas par exemple des lasers à semiconducteurs que l'on veut protéger des réflexions parasites. On a en effet montré que ces sources sont pratiquement insensibles à des réflexions parasites dont la polarisation est perpendiculaire à leur propre polarisation. Dans ce cas, une version intégrée de l'isolateur, constituée d'une couche métallique séparée du grenat par un diélectrique, peut être envisagée. L'inconvénient, dans ce cas, provient de la non-coïncidence entre les plans du laser et du grenat.

Mais dans tous les cas, l'isolateur, en optique intégrée, nécessite une conversion totale entre les deux modes couplés après un aller-retour dans la section non-réciproque. Il est donc impératif d'annuler $\Delta\beta$ donc $\Delta N$.

Différentes solutions ont été envisagées pour résoudre ce problème. L'article "Effets magnétooptiques dans les grenats et leur application à la réalisation d'un isolateur et d'un circulateur optique" de J.P. CASTERA et al. publié dans la Revue Technique THOMSON-CSF - volume 18 - N° 2 de juin 1986, pages 255 à 300 décrit ces différentes solutions. Deux types de solutions ont été envisagées:

- une modulation de l'interaction magnétooptique, donc de la constante de couplage des modes de transmission tel que cela est décrit par exemple dans:

3

- l'article P.K. TIEN et al publié dans Applied Physic Letters, volume 21, de 1972, page 394;
- l'article de R.D. HENR Y publié dans Applied Physic Letters, volume 26, de 1975, page 408;
- une égalisation des constantes de propagation des deux modes couplés tel que décrit dans:
  - l'article de G. HEPNER et al publié dans Applied Optic, volume 13,1974, page 2007;
  - l'article de G. HEPNER et al publié dans Applied Optic, volume 14, 1975, page 1479.

Cependant, toutes les méthodes qui viennent d'être décrites ne sont pas pleinement satisfaisantes, car si elles permettent de diminuer considérablement $\Delta$ , en revanche leur précision rend impossible l'accord de phase parfait entre les modes couplés.

C'est ainsi, par exemple que pour obtenir une isolation parfaite, il faut R = 1 donc $\Delta \beta = \Delta N = 0$ dans l'expression (2). Toute variation de l'écart entre les paramètres de maille de la couche et du substrat par rapport à cette situation idéale entraînera une variation de l'isolation. Le tableau suivant donne pour plusieurs valeurs de

$$\Delta a = a^{\perp}_f - a_s,$$

la biréfringence $\Delta n_e$ correspondante et les performances d'isolement du dispositif.

| $\Delta a$ (Å) | $\Delta n_{ep}$ | I (dB) |
|---|---|---|
| $2,4 \ 10^{-5}$ | $8,6 \ 10^{-7}$ | 40 |
| $7,5 \ 10^{-5}$ | $2,7 \ 10^{-6}$ | 30 |
| $2,4 \ 10^{-4}$ | $8,7 \ 10^{-6}$ | 20 |
| $8,1 \ 10^{-4}$ | $2,9 \ 10^{-5}$ | 10 |

Or, l'incertitude sur l'écart de paramètre de maille relatif que permet le processus d'épitaxie en phase liquide des grenats de type Gd Ga YIG est au mieux :
$\delta a/a = 10^{-5}$ soit $\delta a = 6,2 \ 10^{-4 Å}$. Le tableau précédent montre que dans ces conditions, un isolateur ainsi conçu présentera un taux d'isolation de l'ordre de 10 dB, ce qui est nettement insuffisant pour les applications. Par ailleurs, notre calcul suppose que tous les autres paramètres intervenant sur le taux de conversion sont parfaitement maitrisés, ce qui n'est pas toujours le cas. Parmi ces grandeurs, on peut citer : l'épaisseur du ou des couches minces épitaxiées, l'indice respectif de ces dépôts ainsi que la longueur du guide. Cela pour les guides plans. Dans le cas des guides bidimensionnels, il faut ajouter à ces paramètres la profondeur de l'usinage ionique partiel ainsi que la forme de la section de ces guides.

Il apparaît donc que les exigences imposées à l'épitaxie des grenats pour la réalisation d'un isolateur présentant, par exemple, 50 dB d'isolation ne sont pas applicables dans la pratique, même en supposant des conditions idéales de croissance des matériaux. Pourtant, la maîtrise de l'épitaxie des grenats ferrimagnétiques est remarquable comparée à l'élaboration de matériaux dans d'autres disciplines. La solution doit donc faire appel à un paramètre ajustable p générant une biréfringence et tel que $\frac{\Delta n}{\Delta p}$ soit suffisamment élevé pour obtenir l'accord de phase des deux modes couplés et suffisamment petit pour que la précision sur p permette de conserver un taux d'isolation élevé en toutes circonstances.

L'invention apporte donc une solution à ce problème en agissant sur la température du guide, lequel paramètre "température" a, selon l'invention, un effet sur la biréfringence.

L'invention concerne donc un guide d'onde isolateur monomode intégré comprenant une couche de guidage implantée sur un substrat d'indice de réfraction supérieur à celui du substrat, possédant une entrée et une sortie, au moins un dispositif de polarisation placé à l'entrée de la couche de guidage et orienté de manière à éliminer un mode de polarisation d'un faisceau entrant, après retour dans le guide d'onde à partir de la sortie, caractérisé en ce qu'il comporte au moins un moyen de chauffage associé à la couche de guidage, ce moyen de chauffage (3) chauffe la couche de guidage (1) à une température telle que la différence ($\Delta N$) des indices effectifs du guide pour les modes TE et TM s'annule, la distance de propagation dans le guide étant égale à $\pi/2K$, K étant la constante de Faraday du guide à ladite température.

Les différents objets et caractéristiques de l'invention apparaîtront plus clairement dans la description qui va suivre, faite à titre d'exemple en se reportant aux figures annexées qui représentent :
- la figure 1, un guide d'onde selon les techniques connues ;
- la figure 2, une courbe de fonctionnement du guide de le figure 1 ;
- la figure 3, un exemple de réalisation d'un guide plan monocouche selon l'invention ;
- la figure 4, un exemple de réalisation d'un guide plan bicouche selon l'invention ;

- la figure 5, une variante d'un exemple de réalisation d'un guide plan bicouche selon l'invention ;
- la figure 6, un exemple de réalisation d'une diode laser et d'un isolateur intégré associés selon l'invention.

Comme il a été décrit précédemment, en se reportant notamment au guide tel que représenté en figure 1, la structure d'un guide entraîne une biréfringence $\Delta N_{ST}$ entre les modes couplés. La présente invention a pour objet de compenser cet écart de phase entre modes par une biréfringence $\Delta N_{TE}$ de signe opposé et d'égale amplitude, due à une élévation de température.

Si l'on considère qu'en plus de ces biréfringences, on peut également avoir un terme $\Delta N_{EP}$ généré par l'écart entre les paramètres de maille de la couche et du substrat et éventuellement un terme $\Delta N_{CR}$ qui est dû à la croissance, la biréfringence totale a pour expression :

$$\Delta N = \Delta N_{ST} + \Delta N_{TE} + \Delta N_{EP} + \Delta N_{CR}$$

$\Delta N_{CR}$ peut être annulé par un recuit. Dans le cas contraire, il faut en tenir compte dans les calculs. $\Delta N_{ST}$ vérifie la relation :

$$\Delta N_{ST} = N_{TEo} - N_{TMo}$$

où $N_{TEo}$ et $N_{TMo}$ sont les indices effectifs des modes propres couplés du guide.
$\Delta N_{EP}$, est donné par la réaction :

$$\Delta N_{EP} = N_o^3 \, p44 \, \frac{a_f^\perp - a_s}{a_s}$$

dans laquelle p44 est un coefficient photoélastique propre au matériau du guide.
Quant à $\Delta N_{TE}$, il satisfait l'égalité :

$$\Delta N_{TE} = - N_o^3 \, p44 \, \frac{1 + \nu}{1 - \nu} (\alpha_f - \alpha_s) \, \Delta T$$

où $\nu$ est le coefficient de Poisson ($\nu = 0{,}3$), $\alpha_f$ et $\alpha_s$ les coefficients de dilatation thermique, respectivement de la couche et du substrat et $\Delta T = T - T_o$, T est la température à laquelle est chauffée le grenat et $T_o$ la température ambiante.

Pour avoir une isolation parfaite, il faut $\Delta N = o$. L'invention prévoit donc de chauffer le grenat à une température T telle que :

$$T = T_o + \frac{1}{N_o^3 \, p44} \, \frac{1 - \nu}{1 + \nu} \, \frac{1}{\alpha_f - \alpha_s} (\Delta N_{ST} + \Delta N_{EP} + \Delta N_{CR})$$

$(\alpha_p - \alpha_s)$ dépend des grenats utilisés.
Typiquement, on a :

$\alpha_f - \alpha_s < 0{,}3 . 10^{-5}$ degrés$^{-1}$.

Selon l'invention, on prévoit donc comme cela est représenté en figure 3, un guide plan monocouche muni d'un moyen de chauffage.

Sur cette figure, on trouve un substrat 2 portant une couche de guidage 1 avec un moyen de chauffage 3. Selon ce mode de réalisation, le moyen de chauffage est un dispositif à effet Peltier disposé de façon à chauffer la couche de guidage 1. Le guide d'onde 1 possède une entrée 10 et une sortie 11. A la sortie 11 est associé un polariseur 4. Ce polariseur 4 peut être réalisé sous forme d'une métallisation située au-dessus de la sortie du guide.

Selon l'exemple de réalisation représenté en figure 3, le substrat 2 est associé thermiquement, par collage par exemple, à un dispositif à effet Peltier 3.

A titre d'exemple la couche de guidage peut être réalisée en grenat d'yttrium et de fer (YIG) substitué par du gadolinium et du gallium et obtenue par épitaxie en phase liquide sur un grenat de gadolinium et gallium (GGG).

L'échauffement apporté par le dispositif de chauffage 3 permet de créer une biréfringence qui permet d'améliorer l'efficacité de l'isolateur ainsi réalisé.

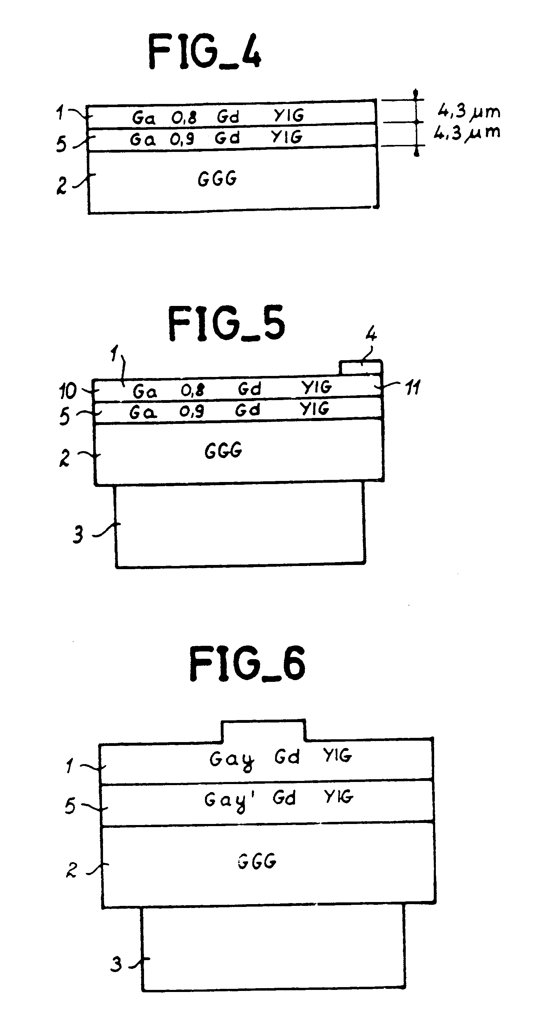

Selon l'invention, on prévoit également une structure telle que représentée en figure 4 et prévoyant une couche de guidage intermédiaire 5, placée entre la couche de guidage 1 et le substrat 2.

Il s'agit d'une couche, réalisée par exemple par épitaxie, présentant un indice légèrement plus faible qui servira de nouveau substrat. L'écart d'indice de réfraction entre cette couche 5 et la couche de guidage 1 est faible ($\simeq 5.10^{-3}$) car on souhaite un guide monomode d'épaisseur compatible avec le diamètre du coeur des fibres monomodes. Cette couche est obtenue en modifiant légèrement le dopage en gallium. Dans ce cas, $\Delta N_{ST}$ est beaucoup plus faible. Ainsi, considérons l'exemple représenté sur la figure 4.

Les indices à $\lambda = 1,15\ \mu m$ et $\lambda = 1,52\ \mu m$ vérifient :

| $\lambda$ ($\mu$m) | 1,15 | 1,52 |
|---|---|---|
| $Ga_{0,8}$Gd YIG | 2,157 | 2,160 |
| $Ga_{0,9}$ Gd YIG | 2,148 | 2,151 |

Le guide ($Ga_{0,8}$ Gd YIG) est monomode et $\Delta N_{ST}$ satisfait :

| $\lambda$ ($\mu$m) | 1,15 | 1,52 |
|---|---|---|
| $\Delta N_{ST}$ | $8,3\ 10^{-5}$ | $15\ 10^{-5}$ |

Ces valeurs sont considérablement plus faibles que pour le guide plan monocouche.

La mesure de $\Delta N_{TE}$ (T) sur ce type de composition donne une première approximation une droite de pente :

$$a = -0,25\ 10^{-5}/°C.$$

On en déduit l'écart de température que l'on doit appliquer au grenat pour avoir une conversion totale.

| $\lambda$ ($\mu$m) | 1,15 | 1,52 |
|---|---|---|
| $\Delta$ T (°C) | 33,2 | 60 |

L'invention prévoit donc, comme représenté en figure 5, un dispositif de chauffage 3 associé à un guide tel que celui qui vient d'être décrit.

Le chauffage est effectué à l'aide d'un dispositif à effet Peltier régulé.

Les températures nécessaires à l'adaptation de phase sont compatibles avec les dispositifs électroniques (en effet, il est en général souhaitable, si l'on doit réguler la température, de travailler à une température supérieure à la température ambiante). Par ailleurs, on peut changer ce point de fonctionnement en ajoutant une biréfringence d'épitaxie (légère modification de la composition).

Le calcul qui vient d'être fait suppose $\Delta N_{EP} = 0$, ce qui est pratiquement le cas pour $Ga_{0,8}$ Gd YIG. Un calcul plus rigoureux montre qu'il existe une légère désadaptation de maille :

$$\Delta a = a_f^\perp - a_s = 8.10^{-4}\ \overset{\circ}{A} \text{ qui conduit à } \Delta N_{EP} = +2,8\ 10^{-5}.$$

Une telle structure a été expérimentée. Les mesures de $\Delta N$ à température ambiante ont montré qu'il existe une biréfringence résiduelle, vraisemblablement de croissance, $\Delta N_{CR} = 4.10^{-5}$. A température ambiante $\Delta N = 16,5\ 10^{-5}$, et une conversion totale (99,4% mesuré) soit $\Delta N \simeq 0$ a été obtenue pour un échauffement $\Delta T = 65°C$, valeur en très bon accord avec les résultats qui précédent.

Pour changer la température de fonctionnement, il faudrait modifier légèrement la composition de la couche de guidage 1, mais également celle de la couche intermédiaire 5, de manière à ce que la lumière se propage toujours dans la couche guidage 1. Ainsi, pour diminuer la température de fonctionnement, on compensera $\Delta N_{ST}$ par $\Delta N_{EP}$ en augmentant la substitution en gallium. Avec une structure $Ga_{1,0}$ Gd YIG / $Ga_{1,1}$ Gd YIG/GGG, en supposant qu'il n'y ait aucune biréfringence de croissance, l'élévation de température ne serait plus que de $\Delta T = 3,5\ °C$.

La température permet d'annuler $\Delta N$ et d'obtenir un taux d'isolation I élevé, mais en contrepartie, toute variation de T s'accompagnera d'une dégradation des performances du dispositif. Le tableau suivant donne les écarts maximum de température à respecter afin de conserver un taux d'isolation donné :

| I dB | $\Delta T(°C)$ |
|------|------|
| 40 | 0,34 |
| 30 | 1,08 |
| 20 | 3,48 |
| 10 | 11,60 |

L'invention est applicable à un guide bidimensionnel.

La section d'un tel guide est représentée sur la figure 6.

Ces guides sont obtenus par usinage partiel de la couche supérieure. Comparé au guide plan double couche, l'usinage du guide 2D a pour effet de rapprocher les courbes de dispersion des modes propres du guide et donc de diminuer $\Delta N_{ST}$. Cela aura pour effet de diminuer $\Delta T$ et donc d'abaisser la température de fonctionnement.

Pour stabiliser la température de fonctionnement de façon efficace, l'invention prévoit d'associer au guide un dispositif à effet Peltier. Comme cela est représenté sur la figure 6, un dispositif à effet Peltier 3 est placé sous le substrat 1 du guide.

Ces dispositifs à effet Peltier sont maintenant compacts et simples de mise en oeuvre et utilisés dans de nombreuses applications (par exemple pour stabiliser les lasers à semiconducteurs).

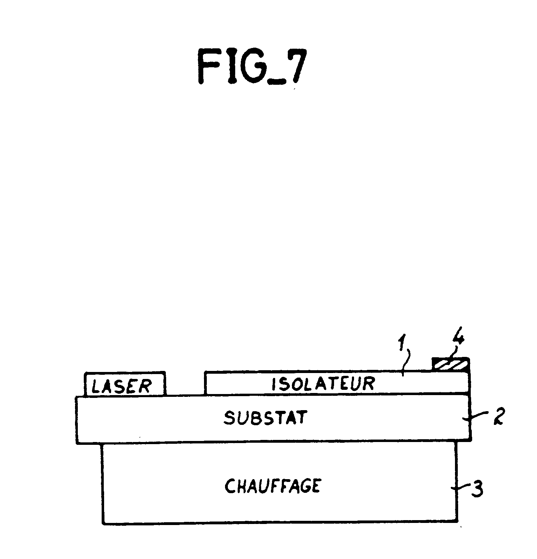

Selon l'invention, on prévoit également dans une réalisation, telle que représentée en figure 7, dans laquelle un guide d'onde isolateur est placé à proximité d'un laser à semiconducteurs 8 pour conduire la lumière qu'il émet, de réaliser le laser 7 et le guide d'onde isolateur 1 sur un même substrat 2. De plus, le guide d'onde est réalisé comme cela est décrit précédemment pour que sa température de fonctionnement soit sensiblement la même que celle du laser. On prévoit alors pour le laser et le guide d'onde un même dispositif à effet Peltier. Un polariseur 4 est placé au-dessus de la sortie 11 du guide d'onde isolateur 1. Le plan de la partie émettrice du laser fait un angle de 45 degrés avec le plan guide d'onde isolateur 1 de façon à fonctionner comme cela est décrit précédemment.

Il est bien évident que la description qui précède n'a été faite qu'à titre d'exemple non limitatif et que d'autres variantes peuvent être envisagées sans sortir du cadre de l'invention. Les exemples numériques, notamment, les exemples de compositions et la position du dispositif de chauffage 3 par rapport au guide n'ont été fournis que pour illustrer la description.

## Revendications

1. Guide d'onde isolateur monomode intégré comprenant une couche de guidage (1) implantée sur un substrat (2), d'indice de réfraction supérieur à celui du substrat, possédant une entrée et une sortie, un dispositif de polarisation (4) placé à une extrémité (11) de la couche de guidage (1) et orienté de manière à éliminer un mode de polarisation d'un faisceau entrant après retour dans le guide d'onde à partir de la sortie, caractérisé en ce qu'il comporte au moins un moyen de chauffage (3) associé à la couche de guidage, ce moyen de chauffage (3) est disposé de manière à chauffer la couche de guidage (1) à une température telle que la différence ($\Delta N$) des indices effectifs du guide pour les modes TE et TM s'annule, la distance de propagation dans le guide étant égale à $\pi/2K$, K étant la constante de Faraday du guide à ladite température.

2. Guide d'onde isolateur selon la revendication 1, caractérisé en ce qu'il comporte une couche intermédiaire de guidage (5) située entre la couche de guidage (1) et le substrat (2) et d'indice de guidage très légèrement inférieur à celui de la couche de guidage, de façon à assurer un guidage monomode et d'épaisseur compatible avec le diamètre d un coeur de fibre monomode pouvant lui être couplée.

**3.** Guide d'onde isolateur selon la revendication 2, caractérisé en ce qu'il comporte un moyen de chauffage (3) associé à le couche de guidage.

**4.** Guide d'onde isolateur selon l'une des revendications 1 ou 3, caractérisé en ce que le moyen de chauffage (3) est un dispositif à effet Peltier.

**5.** Guide d'onde isolateur selon la revendication 2, caractérisé en ce que la couche de guidage (1) et la couche intermédiaire (5) sont réalisées en grenat d'Yttrium et de fer dopé en gallium, le dopage de le couche de guidage (1) étant légèrement plus faible que celui de la couche intermédiaire (5).

**6.** Laser à semiconducteur et isolateur selon l une quelconque des revendications précédentes, ledit laser (8) et ledit guide isolateur (1) étant associés et réalisés sur un même substrat, caractérisé en ce qu'ils comportent une source de chauffage commun.

**7.** Laser à semiconducteur et isolateur associés selon la revendication 6, caractérisé en ce que le dispositif de chauffage (3) est un dispositif à effet Peltier couplé thermique au substrat (2).

**Claims**

**1.** Integrated single-mode isolator waveguide comprising a guiding layer (1) implanted on a substrate (2), of refractive index greater than that of the substrate, having an input and an output, a polarisation device (4) placed at one end (11) of the guiding layer (1) and oriented so as to eliminate one polarisation mode of a beam entering after reflection in the waveguide from the output, characterised in that it comprises at least one heating means (3) associated with the guiding layer, this heating means (3) is disposed so as to heat the guiding layer (1) to a temperature such that the difference ($\Delta N$) in the effective indices of the guide for the TE and TM modes is cancelled, the propagation distance in the guide being equal to $\pi/2K$, K being the Faraday constant of the guide at the said temperature.

**2.** Isolator waveguide according to Claim 1, characterised in that it comprises an intermediate guiding layer (5) situated between the guiding layer (1) and the substrate (2), and of guiding index very slightly less than that of the guiding layer, so as to ensure single-mode guiding, and of thickness compatible with the diameter of a single-mode fibre core which can be coupled to it.

**3.** Isolator waveguide according to Claim 2, characterised in that it comprises a heating means (3) associated with the guiding layer.

**4.** Isolator waveguide according to one of Claims 1 to 3, characterised in that the heating means (3) is a Peltier-effect device.

**5.** Isolator waveguide according to Claim 2, characterised in that the guiding layer (1) and the intermediate layer (5) are made from gallium-doped yttrium iron garnet, the doping of the guiding layer (1) being slightly less than that of the intermediate layer (5).

**6.** Semiconductor laser and isolator according to any one or the preceding claims, the said laser (8) and the said isolator guide (1) being combined and produced on the same substrate, characterised in that they comprise a common heating source.

**7.** Combined semiconductor laser and isolator according to Claim 6, characterised in that the heating device (3) is a Peltier-effect device thermally coupled to the substrate (2).

**Patentansprüche**

**1.** Isolierender integrierter Monomode-Wellenleiter mit einer wellenleitenden Schicht (1), die in einem Substrat (2) implantiert ist und einen höheren Brechungsindex als das Substrat sowie einen Eingang und einen Ausgang besitzt, mit einer Polarisationsvorrichtung (4), die an einem Ende (11) der wellenleitenden Schicht (1) angebracht und so ausgerichtet ist, daß sie einen Polarisationsmodus eines nach Rückkehr vom Ausgang des Wellenleiters eintretenden Strahls eliminiert, dadurch gekennzeichnet, daß er außerdem mindestens ein Heizmittel (3) aufweist, das der wellenleitenden Schicht zugeordnet ist und so angeordnet ist, daß es die wellenleitende Schicht (1) auf eine solche Temperatur erwärmt, daß die Differenz (ΔN) der effektiven Indices des Wellenleiters für die Modi TE und TM zu Null wird, wobei die Fortpflanzungsstrecke im Wellenleiter gleich $\pi/2K$ ist und K die Faraday-Konstante des Wellenleiters bei dieser Temperatur ist.

2. Isolierender Wellenleiter nach Anspruch 1, dadurch gekennzeichnet, daß er eine lichtleitende Zwischenschicht (5) zwischen der wellenleitenden Schicht (1) und dem Substrat (2) besitzt, deren Brechungsindex geringfügig kleiner als der der wellenleitenden Schicht ist,, derart, daß eine Monomode-Wellenleitung gewährleistet ist, wobei die Dicke dieser Schicht mit dem Durchmesser eines Kerns einer mit dem Wellanleiter zu koppelnden Monomode-Lichtleiterfaser kompatibel ist.

3. Isolierender Wellenleiter nach Anspruch 2, dadurch gekennzeichnet, daß er ein Heizmittel (3) aufweist, das der wellenleitenden Schicht zugeordnet ist.

4. Isolierender Wellenleiter nach einem der Ansprüche 1 oder 3, dadurch gekennzeichnet, daß das Heizmittel (3) eine Peltier-Effekt-Vorrichtung ist.

5. Isolierender Wellenleiter nach Anspruch 2, dadurch gekennzeichnet, daß die wellenleitende Schicht (1) und die Zwischenschicht (5) aus Yttrium- und Eisengranat mit Galliumdotierung gebildet werden, wobei die Dotierung der wellenleitenden Schicht (1) geringfügig niedriger als die der Zwischenschicht (5) ist.

6. Halbleiterlaser und Isolator nach einem beliebigen der vorhergehenden Ansprüche, wobei der Laser (8) und der isolierende Wellenleiter (1) einander zugeordnet sind und auf einem gemeinsamen Substrat liegen, dadurch gekennzeichnet, daß sie eine gemeinsame Wärmequelle besitzen.

7. Halbleiterlaser und zugeordneter Isolator nach Anspruch 6, dadurch gekennzeichnet, daß die Heizvorrichtung (3) eine Peltier-Effekt-Vorrichtung ist, die mit dem Substrat (2) thermisch gekoppelt ist.

# FIG_1

LASER — P1 — ISOLATEUR I — P2

# FIG_2

R

INTENSITE DES MODES

mode incident

mode couplé

$\dfrac{4K^2}{4K^2+\Delta\beta^2}$

O

$\dfrac{\pi}{(4K^2+\Delta\beta^2)^{1/2}}$

$L_x$

LONGUEUR DE PROPAGATION

# FIG_3

1    n0    4

10    n1    11

n2    2

3

# FIG_4

```
1 —    Ga   0,8   Gd      YIG         ⫶   4,3 μm
5 —    Ga   0,9   Gd      YIG             4,3 μm
2 —              GGG
```

# FIG_5

```
                                        4
      1                                ⎍
10 —     Ga   0,8     Gd      YIG      — 11
5 —      Ga   0,9     Gd      YIG
2 —                GGG

3 —
```

# FIG_6

```
1 —       Gay    Gd   YIG
5 —       Gay'   Gd   YIG
2 —              GGG

3 —
```

# FIG_7